Europäisches Patentamt

European Patent Office

Office européen des brevets

(11) Publication number: **0 156 647**
**B1**

## (12) EUROPEAN PATENT SPECIFICATION

(45) Date of publication of patent specification: **19.07.89**

(21) Application number: **85302159.0**

(22) Date of filing: **28.03.85**

(51) Int. Cl.⁴: **H 01 L 29/62,** H 01 L 29/72, H 01 L 29/80

(54) Thin film transistor and method of making the same.

(30) Priority: **30.03.84 JP 60669/84**

(43) Date of publication of application:
**02.10.85 Bulletin 85/40**

(45) Publication of the grant of the patent:
**19.07.89 Bulletin 89/29**

(84) Designated Contracting States:
**DE FR GB**

(56) References cited:
**EP-A-0 001 374**

**THIN SOLID FILMS, vol. 55, no. 1, November 1978, pages 137-141, Lausanne, CH; A. DENEUVILLE et al.: "A thin film metal base transistor structure with amorphous silicon"**
**IBM TECHNICAL DISCLOSURE BULLETIN, vol. 20, no. 9, February 1978, pages 3731-3734, New York, US; M.H. BRODSKY et al.: "Light-sensitive thin-film metal base transistor"**

(73) Proprietor: **HITACHI, LTD.**
**6, Kanda Surugadai 4-chome Chiyoda-ku Tokyo (JP)**

(72) Inventor: **Tsukada, Toshihisa**
**3-29-2, Sekimae**
**Musashino-shi Tokyo (JP)**
Inventor: **Nakano, Toshio**
**2067-8, Kaneda Chosei-mura**
**Chosei-gun Chiba-ken (JP)**
Inventor: **Sasano, Akira**
**2196-451, Hirai Hinodemachi**
**Nishitama-gun Tokyo (JP)**
Inventor: **Seki, Koichi**
**D408, 2-32, Koyasu-cho**
**Hachioji-shi Tokyo (JP)**

(74) Representative: **Calderbank, Thomas Roger et al**
**MEWBURN ELLIS & CO. 2/3 Cursitor Street London EC4A 1BQ (GB)**

## Description

The present invention relates to a thin film transistor (hereinafter referred to as a TFT), and may be, for example, a switching transistor which is suitable for use in a liquid crystal display panel.

Thin film type field effect transistors (TFT's) are known from e.g. U.S. Patent 3,191,061 and U.S. Patent 4,351,856.

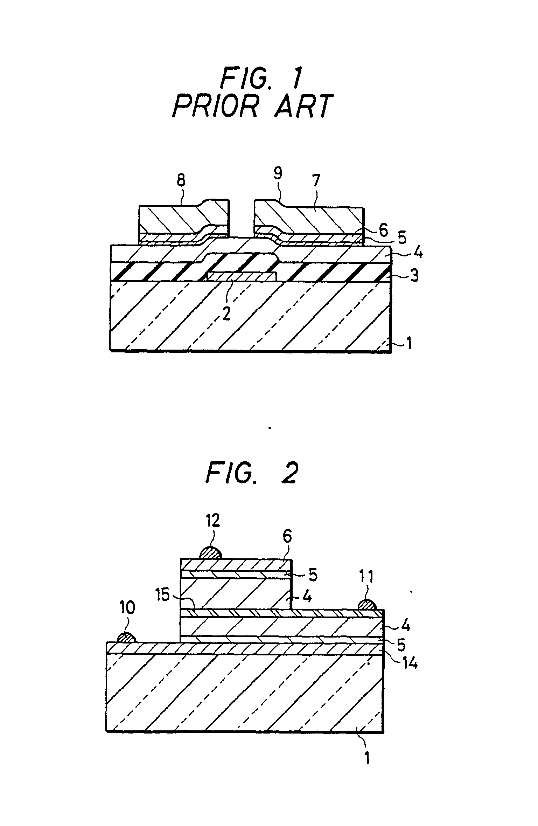

Fig. 1 of the accompanying drawings shows a sectional view of an example of a thin film transistor (FET type) employing hydrogenated amorphous silicon (a-Si). A method of making this TFT will now be briefly explained. A glass substrate 1 has a gate electrode 2 formed thereon, on which electrode 2 is formed an insulator 3, an intrinsic (i) layer 4, and an n-type layer 5 of amorphous silicon. Thereafter, electrode metals such as Cr 6 and Al 7 are evaporated or deposited, and they are processed to form source and drain electrodes 8 and 7 respectively. Using the fabricated pattern as a mask, the n-type layer of a-Si is etched by dry etching. The TFT thus manufactured is an enhancement-mode FET, the drain current of which has an ON/OFF ratio reaching 6 orders of magnitude. The OFF current is also as low as 5 pA (at a gate width of 300 μ and a gate length of 10 μ), and the FET is very suitable for driving liquid crystal. Since, however, the mobility of amorphous silicon is low, the switching time of the TFT is as long as approximately 10 μs. When a TFT is used as a switching device to drive the matrix of a liquid crystal display, operation by one point at a time is difficult. Accordingly, the matrix is driven by operation one line at a time.

It has been found that the TFT causes a drift during operation under the subtle influences of interface properties. More specifically, as the drain current is caused to flow, a shift on the threshold voltage $V_T$ is observed, and the OFF current increases. The reason is thought to be that charges are injected into the gate insulator and are trapped there to give rise to semi-fixed charges. Thin film transistors comprising regions formed by interfacial reaction between metal and amorphous silicon and having metal layers as the conductive layer of the base electrode are known from "Thin Solid Films", Vol. 55, No. 1, November 1978 pages 137—141; EP—A—0001374; and IBM Technical Disclosure Bulletin, Vol. 20, No. 9 February 1978, pages 3731—3734. The disclosure of these documents is substantially equivalent, and they therefore correspond to the pre-characterising part of claim 1.

The present invention seeks to provide a thin film transistor of high speed and high stability. In a first aspect, it does this by providing an amorphous silicon thin film transistor having an emitter, a control electrode, and a collector, the control electrode having a conductive layer formed by an interfacial reaction between amorphous silicon and metal; characterised in that:

the conductive layer(s) of the control electrode has at least a part on which no excess unreacted metal exists.

The emitter and collector also may include amorphous silicon, preferably hydrogenated. Several arrangements are possible, e.g. n i-conductive layer-in, n i p-conductive layer-p i n where n and p are the conductivity types of amorphous silicon layers and i is intrinsic semi-conductor.

In a second aspect the present invention provides a thin film transistor comprising a glass substrate, a lower electrode on the substrate, an emitter terminal which is connected to said lower electrode, a first n-type hydrogenated amorphous silicon layer on said lower electrode, a first intrinsic hydrogenated amorphous silicon layer on the first n-type hydrogenated amorphous silicon layer, a layer which is formed by an interfacial reaction between metal and amorphous silicon on at least a portion of which no excess unreacted metal exists and which layer is on the first intrinsic hydrogenated amorphous silicon layer, a base electrode which is connected to an interface between the metal and the amorphous silicon, a second intrinsic hydrogenated amorphous silicon layer on the interfacial reaction layer, a second n-type hydrogenated amorphous silicon layer on the second intrinsic hydrogenated amorphous silicon layer, and a collector electrode on the second n-type hydrogenated amorphous silicon layer.

In a third aspect the present invention provides a thin film transistor comprising a glass substrate, a lower electrode on said substrate, a first n-type hydrogenated amorphous silicon layer on the lower electrode, a first intrinsic hydrogenated amorphous silicon layer on the first n-type hydrogenated amorphous silicon layer, a first p-type hydrogenated amorphous silicon layer on the first intrinsic hydrogenated amorphous silicon layer, a layer which is formed by an interfacial reaction between metal and amorphous silicon and which is on the first p-type hydrogenated amorphous silicon on at least a part of which no excess unreacted metal exists, a second p-type hydrogenated amorphous silicon on the interfacial reaction layer, a second intrinsic hydrogenated amorphous silicon layer on the second p-type hydrogenated amorphous silicon layer, a second n-type hydrogenated amorphous silicon layer on the second intrinsic hydrogenated amorphous silicon layer, and a metal layer on the second n-type hydrogenated amorphous silicon layer; the lower electrode acting as an emitter electrode, the interfacial reaction layer acting as a base electrode, and the metal layer acting as a collector electrode.

In a fourth aspect the present invention provides a transistor according to any one of the preceding claims wherein the metal is Cr.

Embodiments of the present invention will now be described, by way of example, with reference to the accompanying drawings in which:

Fig. 1 is a sectional view of a prior-art a-Si TFT and has already been described;

Fig. 2 is a sectional view showing a first embodiment of a TFT according to the present invention;

Fig. 3 is a sectional view of the transistor shown in Fig. 2 as seen in a direction orthogonal to the interdigitated electrode thereof;

Fig. 4 is a connection diagram of the bias voltage of the transistor of Fig. 2; and

Figs. 5 and 6 are sectional views of second and third embodiments of a TFT according to the present invention.

Embodiment 1

Fig. 2 shows a first embodiment of the present invention. The structure of this TFT resembles the so-called permeable base transistor (PBT), and employs as its base a layer formed by the interfacial reaction between metals and a-Si.

Fabrication

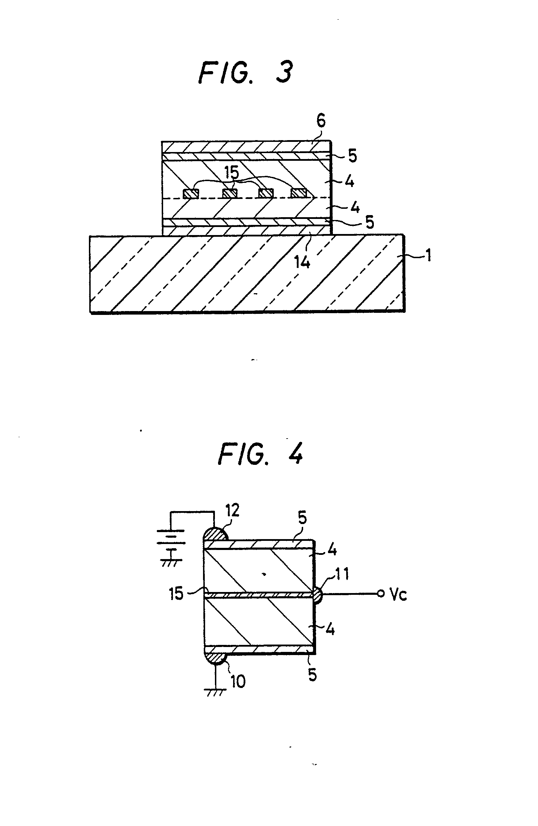

A method of fabrication of the FTF of Fig. 2 will be explained. A Ta lower electrode 14 is formed by sputter evaporation on a glass substrate 1 to a thickness of 0.3 μm, the atmosphere being e.g. Ar gas. A layer 5 of hydrogenated amorphous silicon containing P (a-Si:H(n)) is formed on the electrode 14 at a substrate temperature of 230°C by a plasma Chemical Vapour Deposition (CVD) process using a gas in which $PH_3$ and $SiH_4$ are mixed (mixing ratio: $PH_3/SiH_4 \geq 0.5$ V%). Subsequently, an a-Si:H(i) layer 4 is formed using only $SiH_4$ gas. After the formation of the a-Si:H(i) layer 4, Cr is evaporated or deposited on the whole surface thereof to a thickness of 0.1 μm. Thus, a thin interfacial reaction layer 15 is formed by the interfacial reaction between a-Si and Cr. The substrate temperature during the evaporation is preferably between 100 and 300°C. The reason for this is that the reaction rate is slow below 100°C, while hydrogen begins to get away from a-Si at above 300°C. The required heating time in this case is about 30 to 60 minutes. Even when Cr is evaporated at room temperature and then heat-treated under the same condition, the interfacial reaction between a-Si and Cr similarly takes place to form a thin interfacial reaction layer. The thickness of the interfacial reaction layer is 10 nm or less. After the heat treatment, the Cr is removed. The etchant used may be an aqueous solution containing 250 gr./lit. of ceric ammonium nitrate. After the removal of the Cr, the layer of the interfacial reaction between Cr and amorphous silicon is etched so as to be left in an interdigitated shape. The etchant used may be $HF:HNO_3:H_2O$ at a relative concentration of 1:1:30. The interfacial reaction layer left is in the shape of stripes at pitches of 2 μm and widths of 1.5 μm as illustrated in Fig. 3. It is also possible to etch the interfacial reaction layer by such means as a plasma asher. Subsequently, an i-layer 4 and n-layer 5 of a-Si are deposited, and an electrode metal (Cr) 6 is evaporated. Then, the transistor is finished.

Operation

The operation of the transistor is as follows. As illustrated in Fig. 4, an emitter electrode 10 is earthed, a collector electrode 12 is positively biased, and a base electrode 11 is supplied with a control voltage $V_c$ to be negatively or positively biased. The interfacial reaction layer 15 and the i-layer of a-Si 4 form a Schottky barrier. Accordingly, an emitter-base section operates as a Schottky diode. By reverse-biasing this diode, a reverse bias is applied to the Schottky barrier, and a depletion layer spreads in the vicinity of the striped base electrode. Since the width of the depletion layer is substantially equal to the gap of the layer of the interfacial reaction between Cr and amorphous silicon, the path through which electrons flow can be controlled by varying the voltage to be applied to the base, and in turn, the collector current can be controlled. Thus, the structure of this device can be called a solid state triode when the base is considered to be the grid of a triode, and the operation mechanism is also similar.

It is advantageous to use the layer of the interfacial reaction between Cr and amorphous silicon for achieving this structure. More specifically, the interfacial reaction layer is preferably 10 nm or less, and virtually no obstacle is involved in burying it into a-Si. Further, the interfacial reaction layer may have a low resistance of approximately $10^4$ Ω/□ in spite of being such a thin film and can satisfactorily function as a control electrode.

Even when the emitter and collector of the present structure are reversed, a similar operation is possible.

In the embodiment, Cr has been removed after the formation of the interfacial reaction layer, and the region of the removal has not been especially referred to. A transistor operation region is important as the region where Cr is removed, and of course, it is more convenient to leave Cr in the other region because the series resistance can be reduced.

Embodiment 2:

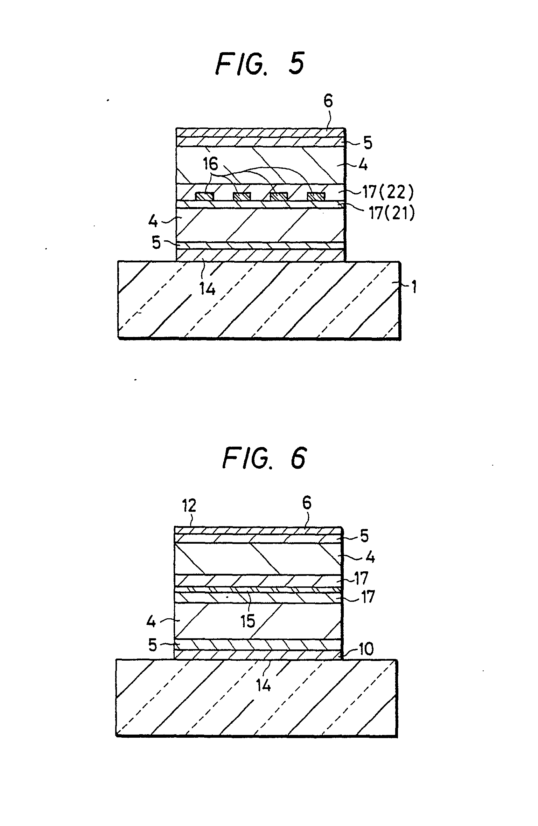

Fig. 5 shows a second embodiment of the present invention. A collector electrode Ta 14 is deposited on a glass substrate 1 as in the foregoing embodiment, whereupon amorphous silicon a-Si is formed in the order of an n-type layer 5, an intrinsic (i) layer 4 and a p-type layer 17 by a plasma CVD process. The p-type layer is formed using a gas in which $B_2H_6$ gas and $SiH_4$ gas are mixed (mixing ratio: $B_2H_6/SiH_4 \geq 0.5$ V%). The thicknesses of the n-layer, i-layer and p-layer are 30 nm, 500 nm and 20 nm, respectively. Subsequently, nickel ni is evaporated and heat-treated (at 220°C for 30 minutes) to form a layer 16 of the interfacial reaction between Ni and a-Si, which is processed into the shape of stripes as illustrated. The interfacial reaction layer which remains after removing the Ni layer functions as a base electrode. An aqueous solution containing 300 gr./lit. of ferric chloride may be used for the etching of Ni. Using the CVD process again, a p-layer 17, an i-layer 4 and an n-layer 5 are successively formed this time. Lastly, a Cr layer 6 is evaporated as an emitted electrode. The thicknesses of the a-Si p-layer, i-layer and n-layer are 10 nm, 500 nm and 20 nm, respectively.

As for an ordinary bipolar transistor, this transistor operates by applying a forward bias across the emitter and the base, and a reverse bias across the base and the collector. Unlike the electrode 6, the electrode 14 may be selected as the emitter electrode. This embodiment may produce an a-Si transistor whose collector current is controlled by the forward bias applied to the base and which has a high response speed.

Although a-Si p-layers 21 and 22 are used in the present embodiment, similar results are attained even in the absence of either p-layer.

Embodiment 3:

Fig. 6 shows a third embodiment of the present invention. The fabricating method of this embodiment is similar to that of the structure shown in Fig. 5, and shall be therefore omitted. The point of difference is the configuration of the base electrode, which is not processed into stripes. In the second embodiment using an interdigitated electrode, the current passes through the semiconductor regions between the electrodes, and the transistor operation is effected by controlling this path. On the other hand, in the third embodiment, a layer of the interfacial reaction between a-Si and chromium is formed over the whole area, and carriers travel across this interfacial reaction layer. This is based on the same operating principle as that of the so-called metal base transistor. Practical use of the ordinary metal base transistor has had to be abandoned because it is difficult to deposit a thin metal layer reliably and uniformly. The layer of the interfacial reaction between a-Si and metals as stated in the present invention is very suitable as the base material of the metal base transistor owing to, not only the extreme thinness of preferably not more than 10 nm, but also low electric resistance and chemical stability.

The transistor operation is effected by applying a forward bias across the emitter 10 (or 12) and the base 15 and a reverse bias across the base and the collector 12 (or 10). As the thickness of the base is smaller, the transfer efficiency is higher and the base transit time is shorter, so that the transistor has excellent high speed performance. The thickness of the interfacial reaction layer may be 3 mm or less, and favorable characteristics are attained.

While, in the present embodiment, the construction in which the p-i-n diodes are disposed on both the sides of the interfacial reaction layer has been explained, the purport of the present invention is not always restricted thereto. Similar effects are attained even with a structure in which n-i-p layers—an interfacial reaction layer—i-n layers are disposed as viewed from the emitter electrode side. In this case, the Schottky barrier is utilized.

Further, this holds true for a structure in which n-i layers—an interfacial reaction layer—i-n layers are disposed from the emitter side.

One of the advantages of the present invention resides in that the amorphous silicon a-Si may be readily deposited on a metal or on an interfacial metal reaction layer. Another merit of a-Si is that the magnitude of band gap energy can be varied, and a wide-gap emitter transistor can be fabricated by making use of this. That is, a heterotransistor of more enhanced injection efficiency can be fabricated by replacing the a-Si on the emitter side with a-SiC wholly or partly. In addition, the characteristics can be improved if the a-Si layers on the emitter and collector sides are made of layers containing ·e.g. carbon (C) or germanium (Ge).

The foregoing embodiments have used Cr and Ni for forming layers of the interfacial reactions between the metals and a-Si, but metal used is not restricted to these specific uses. The same effects can be produced using a conductor layer which is formed at the interface between the metal and a-Si by the interfacial reaction of the a-Si with a metal film that contains, as an alternative or in addition to Cr and Ni, at least one of Mo, W, Ti, V, Zr, Nb, Ta, Pt, Hf, Pd, Rh and Co.

## Claims

1. An amorphous silicon thin film transistor having an emitter (4,5,14,10), a control electrode (11,15), and a collector (4,5,6,12), the control electrode having a conductive layer (15) formed by an interfacial reaction between amorphous silicon and metal; characterised in that: the conductive layer(s) of the control electrode has at least a part on which no excess unreacted metal exists.

2. A transistor according to claim 1, wherein the emitter includes a first hydrogenated amorphous silicon layer (5) and a first intrinsic hydrogenated amorphous silicon layer (4), and the collector includes a second hydrogenated amorphous silicon layer (5) and a second intrinsic hydrogenated silicon layer (4), the hydrogenated silicon layer (5) being of the same conductivity type and each being further from the conductive layer (15) than the corresponding intrinsic semiconductor layer (4).

3. An amorphous silicon thin film transistor comprising a glass substrate, a lower electrode on the substrate, an emitter terminal which is connected to said lower electrode, a first n-type hydrogenated amorphous silicon layer on said lower electrode, a first intrinsic hydrogenated amorphous silicon layer on the first n-type hydrogenated amorphous silicon layer, a layer which is formed by an interfacial reaction between metal and amorphous silicon on at least a portion of which no excess unreacted metal exists and which layer is on the first intrinsic hydrogenated amorphous silicon layer, a base electrode which is connected to an interface between the metal and the amorphous silicon, a second intrinsic hydrogenated amorphous silicon layer on the interfacial reaction layer, a second n-type hydrogenated amorphous silicon layer on the second intrinsic hydrogenated amorphous silicon layer, and a collector electrode on the second n-type hydrogenated amorphous silicon layer.

4. A transistor according to claim 3, wherein the interfacial reaction layer is on a whole area of the first intrinsic hydrogenated amorphous silicon layer.

5. An amorphous silicon thin film transistor comprising a glass substrate, a lower electrode on said substrate, a first n-type hydrogenated amorphous silicon layer on the lower electrode, a first intrinsic hydrogenated amorphous silicon layer on the first n-type hydrogenated amorphous silicon layer, a first p-type hydrogenated amorphous silicon layer on the first intrinsic hydrogenated amorphous silicon layer, a layer which is formed by an interfacial reaction between metal and amorphous silicon and which is on the first p-type hydrogenated amorphous silicon, on at least a part of which no excess unreacted metal exists, a second p-type hydrogenated amorphous silicon on the interfacial reaction layer, a second intrinsic hydrogenated amorphous silicon layer on the second p-type hydrogenated amorphous silicon layer, a second n-type hydrogenated amorphous silicon layer on the second intrinsic hydrogenated amorphous silicon layer, and a metal layer on the second n-type hydrogenated amorphous silicon layer;

the lower electrode acting as an emitter electrode, the interfacial reaction layer acting as a base electrode, and the metal layer acting as a collector electrode.

6. A transistor according to claim 5, wherein the interfacial reaction layer is on a whole area of the first p-type hydrogenated amorphous silicon layer.

7. A transistor according to any one of the preceding claims, wherein the interfacial reaction layer is in the form of stripes.

8. A transistor according to any one of the preceding claims, wherein the thickness of the interfacial reaction layer is not more than 10 nm.

9. A transistor according to any one of claims 1 to 8 wherein the metal includes at least one of Cr, Mo, W, Ta, Ti, Pt, V, Zr, Nb, Ni, Hf, Pd, Rh and Co.

10. A transistor according to any one of the preceding claims wherein the metal is Cr.

11. A transistor according to any one of claims 1 to 8 wherein the metal is Ni.

12. A method of making an amorphous silicon thin film transistor, comprising the steps of:

a) evaporating a lower electrode on a glass substrate,

b) providing a first n-type hydrogenated amorphous silicon layer on the lower electrode.

c) providing a first intrinsic hydrogenated amorphous silicon layer on the first n-type hydrogenated amorphous silicon layer,

d) providing a metal layer on a whole surface of the resultant structure,

e) forming the metal layer and a layer of an interfacial reaction between the metal layer and the amorphous silicon layer into a desired shape,

f) removing the excess unreacted metal from at least a part of the layer of interfacial reaction,

g) providing a second intrinsic hydrogenated amorphous silicon layer on the interfacial reaction layer,

h) providing a second n-type hydrogenated amorphous silicon layer on the second intrinsic hydrogenated amorphous silicon layer, and

i) providing desired electrode wiring.

13. A method according to claim 12 wherein the thickness of the interfacial reaction layer is not more more than 10 nm.

14. A method according to claim 12 or claim 13 wherein the interfacial reaction layer is in the shape of stripes.

15. A method according to any one of claims 12 to 14, wherein the metal layer is evaporated at a temperature of 100 to 300°C.

16. A method according to any one of claims 12 to 15 wherein the metal includes at least one of Cr, Mo, W, Ta, Ti, Pt, V, Zr, Nb, Ni, Hf, Pd, Rh and Co.

17. A method according to any one of claims 12 to 16 wherein the metal is Cr.

18. A method according to any one of claims 12 to 16 wherein the metal is Ni.

**Patentansprüche**

1. Dünnfilmtransistor aus amorphem Silizium mit einem Emitter (4, 5, 14, 10), einer Steuerelektrode (11, 15) und einem Kollektor (4, 5, 6, 12), wobei die Steuerelektrode eine leitfähige Schicht (15) hat, die durch eine Grenzflächenreaktion zwischen amorphem Silizium und Metall gebildet ist; dadurch gekennzeichnet,

daß die leitfähige(n) Schicht(en) der Steuerelektrode zumindest einen Teil hat (haben), auf dem sich kein überschüssiges unreagiertes Metall befindet.

2. Transistor nach Anspruch 1, wobei der Emitter eine erste hydrierte amorphe Siliziumschicht (5) sowie eine erste eigenleitende hydrierte amorphe Siliziumschicht (4) enthält und der Kollektor eine zweite hydrierte amorphe Siliziumschicht (5) sowie eine zweite eigenleitende hydrierte Siliziumschicht (4) enthält, wobei die hydrierten Siliziumschichten (5) vom selben Leitfähigkeitstyp sind und jeweils weiter von der leitfähigen Schicht (15) entfernt sind als die entsprechende eigenleitende Halbleiterschicht (4).

3. Dünnfilmtransistor aus amorphem Silizium mit einem Glassubstrat, einer unteren Elektrode auf dem Substrat, einem Emitteranschluß, der mit der unteren Elektrode verbunden ist, einer ersten hydrierten amorphen n-Typ-Siliziumschicht auf der unteren Elektrode, einer ersten eigenleitenden hydrierten amorphen Siliziumschicht auf der ersten hydrierten amorphen n-Typ-Siliziumschicht, einer Schicht, die durch eine Grenzflächenreaktion zwischen Metall und amorphem Silizium gebildet ist, auf zumindest einem Bereich von der sich kein überschüssiges unreagiertes Metall befindet und die auf der ersten eigenleitenden hydrierten amorphen Siliziumschicht liegt, einer Basiselektrode, die mit einer Grenzfläche zwischen dem Metall und dem amorphen Silizium verbunden ist, einer zweiten eigenleitenden hydrierten amorphen Siliziumschicht auf der Grenzflächenreaktion-Schicht, einer zweiten hydrierten amorphen n-Typ-Siliziumschicht auf der zweiten eigenleitenden hydrierten amorphen Siliziumschicht und einer Kollektorelektrode auf der zweite hydrierten amorphen n-Typ-Siliziumschicht.

4. Transistor nach Anspruch 3, wobei sich die Grenzflächenreaktion-Schicht auf einem Gesamtbereich der ersten eigenleitenden hydrierten amorphen Siliziumschicht befindet.

5. Dünnfilmtransistor aus amorphem Silizium mit einem Glassubtrat, einer unteren Elektrode auf dem Substrat, einer ersten hydrierten amorphen n-Typ-Siliziumschicht auf der unteren Elektrode, einer ersten eigenleitenden hydrierten amorphen Siliziumschicht auf der ersten hydrierten amorphen n-Typ-Siliziumschicht, einer ersten hydrierten amorphen p-Typ-Siliziumschicht auf der ersten eigenleitenden hydrierten amorphen Siliziumschicht, einer Schicht, die durch eine Grenzflächenreaktion zwischen Metall und amorphem Silizium gebildet ist und die auf der ersten hydrierten amorphen p-Typ-Siliziumschicht liegt, auf zumindest einem Teil von der sich kein überschüssiges unreagiertes Metall befindet, einer zweiten hydrierten amorphen p-Typ-Siliziumschicht auf der Grenzflächenreaktion-Schicht, einer zweiten eigenleitenden hydrierten amorphen Siliziumschicht auf der zweiten hydrierten amorphen p-Typ-Siliziumschicht, einer zweiten hydrierten amorphen n-Typ-Siliziumschicht auf der zweiten eigenleitenden hydrierten amorphen Siliziumschicht und einer Metallschicht auf der zweiten hydrierten amorphen n-Typ-Siliziumschicht;

wobei die untere Elektrode als ein Emitterelektrode, die Grenzflächenreaktion-Schicht als eine Basiselektrode und die Metallschicht als eine Kollektorelektrode wirkt.

6. Transistor nach Anspruch 5, wobei sich die Grenzflächenreaktion-Schicht auf einem gesamtbereich der ersten hydrierten amorphen p-Typ-Siliziumschicht befindet.

7. Transistor nach einem der vorhergehenden Ansprüche, wobei die Grenzflächenreaktion-Schicht streifenförmig ist.

8. Transistor nach einem der vorhergehenden Ansprüche, wobei die Dicke der Grenzflächenreaktion-Schicht nicht größer als 10 nm ist.

9. Transistor nach einem der Ansprüche 1 bis 8, wobei das Metall zumindest eines der Elemente Cr, Mo, W, Ta, Ti, Pt, V, Zr, Nb, Ni, Hf, Pd, Rh und Co enthält.

10. Transistor nach einem der vorhergehenden Ansprüche, wobei das Metall Cr ist.

11. Transistor nach einem der Ansprüche 1 bis 8, wobei das Metall Ni ist.

12. Verfahren yum Herstellen eines Dünnfilmtransistors aus amorphem Silizium mit folgenden Schritten:

a) Aufdampfen einer unteren Elektrode auf ein Glassubstrat,

b) Vorsehen einer ersten hydrierten amorphen n-Typ-Siliziumschicht auf der unteren Elektrode.

c) Vorsehen einer ersten eigenleitenden hydrierten amorphen Siliziumschicht auf der ersten hydrierten amorphen n-Typ-Siliziumschicht,

d) Vorsehen einer Metallschicht auf einer Gesamtfläche der resultierenden Struktur,

e) Ausbilden der Metallschicht und einer Schicht aus einer Grenzflächenreaktion zwischen der Metallschicht und der amorphen Siliziumschicht in einer gewünschten Form,

f) Entfernen des überschüssigen unreagierten Metalls von zumindest einem Teil der Schicht aus der Grenzflächenreaktion,

g) Vorsehen einer zweiten eigenleitenden hydrierten amorphen Siliziumschicht auf der Grenzflächenreaktion-Schicht,

h) Vorsehen einer zweiten hydrierten amorphen n-Typ-Siliziumschicht auf der zweiten eigenleitenden hydrierten amorphen Siliziumschicht und

i) Vorsehen von gewünschter Elektrodenverdrahtung.

13. Verfahren nach Anspruch 12, wobei die Dicke der Grenzflächenreaktion-Schicht nicht mehr als 10 nm beträgt.

14. Verfahren nach Anspruch 12 oder Anspruch 13, wobei die Grenzflächenreaktion-Schicht streifenförmig ist.

15. Verfahren nach einem der Ansprüche 12 bis 14, wobei die Metallschicht bei einer Temperatur von 100 bis 300°C aufgedampft wird.

16. Verfahren nach einem der Ansprüche 12 bis 15, wobei das Metall zumindest eines der Elemente Cr, Mo, W, Ta, Ti, Pt, V, Zr, Nb, Ni, Hf, Pd, Rh und Co enthält.

17. Verfahren nach einem der Ansprüche 12 bis 16, wobei das Metall Cr ist.

18. Verfahren nach einem der Ansprüche 12 bis 16, wobei das Metall Ni ist.

## Revendications

1. Transistor à couches minces formées de silicium amorphe, possédant un émetteur (4,5,14,10), une électrode de commande (11,15) et un collecteur (4,5,6,12), l'électrode de commande possédant une couche conductrice (15) formée au moyen d'une réaction interfaciale entre du silicium amorphe et un métal; caractérisé en ce que la ou les couches conductrices de l'électrode de commande possèdent au moins une partie, sur laquelle il n'existe pas de métal en excès n'ayant pas réagi.

2. Transistor selon la revendication 1, dans lequel l'émetteur comporte une première couche de silicium amorphe hydrogénée (5) et une première couche intrinsèque (4) de silicium amorphe hydrogéné, et le collecteur comporte une seconde couche (5) de silicium amorphe hydrogéné et une seconde couche intrinsèque (4) de silicium hydrogéné, les couches (5) de silicium hydrogéné possédant le même type de conductivé et étant plus éloignées, chacune, de la couche conductrice (15) que la couche semiconductrice intrinsèque (4) correspondante.

3. Transistor à couches minces formées de silicium amorphe comprenant un substrat en verre, une électrode inférieure située sur le substrat, une borne d'émetteur qui est raccordée à ladite électrode inférieure, une première couche de silicium amorphe hydrogéné de type n, située sur ladite électrode inférieure une première couche intrinsèque de silicium amorphe hydrogéné, située sur la première couche de silicium amorphe hydrogéné de type n, une couche qui est formée au moyen d'une réaction interfaciale entre un métal et du silicium amorphe et sur au moins une partie de laquelle il n'existe pas de métal en excès n'ayant pas réagi, laquelle couche est située sur la première couche intrinsèque en silicium amorphe hydrogéné, une électrode de base, qui est raccordée à une interface située entre le métal et le silicium amorphe, une seconde couche intrinsèque de silicium amorphe hydrogéné située sur la couche produite par réaction interfaciale, une seconde couche de silicium amorphe hydrogéné de type n située sur la seconde couche intrinsèque de silicium amorphe hydrogéné, et une électrode de collecteur située sur la seconde couche de silicium amorphe hydrogéné de type n.

4. Transistor selon wa revendication 3, dans lequel la couche de réaction interfaciale est présente sur toute la surface de la première couche intrinsèque de silicium amorphe hydrogéné.

5. Transistor à couches minces formées de silicium amorphe, comprenant un substrat en verre, une électrode inférieure située sur ledit substrat, une première couche de silicium amorphe hydrogéné de type n, située sur l'électrode inférieure, une première couche intrinsèque de silicium amorphe hydrogéné, située sur la première couche de silicium amorphe hydrogéné de type n, une première couche de silicium amorphe hydrogéné de type p, située sur la première couche intrinsèque de silicium amorphe hydrogéné, une couche qui est formée au moyen d'une réaction interfaciale entre un métal et du silicium amorphe et qui est située sur la première couche de silicium amorphe hydrogéné de type p et sur au moins une partie de laquelle il n'existe aucun métal en excès n'ayant pas réagi, une seconde couche de silicium amorphe hydrogéné de type p, située sur la couche produite par réactimn interfaciale, une seconde couche intrinsèque de silicium amorphe hydrogéné, située sur la seconde couche de silicium amorphe hydrogéné de type p, une seconde couche de silicium amorphe hydrogéné de type n, située sur la seconde couche intrinsèque de silicium amorphe hydrogéné, et une couche métallique située sur la seconde couche de silicium amorphe hydrogéné de type n;

l'électrode inférieure agissant en tant qu'électrode d'émetteur, la couche produite par réaction interfaciale agissant en tant qu'électrode de base et la couche métallique agissant en tant qu'électrode de collecteur.

6. Transistor selon la revendication 5, dans lequel la couche produite par réaction interfaciale s'étend sur l'ensemble de la surface de la première couche de silicium amorphe hydrogéné de type p.

7. Transistor selon l'une quelconque des revendications précédentes, dans lequel la couche produite par réaction interfaciale possède la forme de bandes.

8. Transistor selon l'une quelconque des revendications précédentes, dans lequel l'épaisseur de la couche produite par réaction interfaciale n'est pas supérieure à 10 nm.

9. Transistor selon l'une quelconque des revendications 1 à 8, dans lequel le métal inclut au moins l'un de Cr, Mo, W, Ta, Ti, Pt, V, Zr, Nb, Ni, Hf, Pd, Rh et Co.

10. Transistor selon l'une quelconque des revendications précédentes, dans lequel le métal est du Cr.

11. Transistor selon l'une quelconque des revendications 1 à 8, dans lequel le métal est du Ni.

12. Procédé pour fabriquer un transistor à couches minces formées de silicium amorphe, incluant les étapes consistant à:

a) déposer par évaporation une électrode inférieure sur un substrat en verre,

b) former une première couche de silicium amorphe hydrogéné de type n sur l'électrode inférieure,

c) former une première couche intrinsèque de silicium amorphe hydrogéné sur la première couche de silicium amorphe hydrogéné de type n,

d) former une couche métallique sur l'ensemble de la surface de la structure résultante,

e) donner une forme désirée à la couche métallique et à une couche obtenue au moyen d'une réaction interfaciale entre la couche métallique et la couche de silicium amorphe,

f) retirer le métal en excès n'ayant pas réagi, d'au moins une partie de la couche produite par réaction interfaciale,

g) former une seconde couche intrinsèque de silicium amorphe hydrogéné sur la couche produite par réaction interfaciale,

h) former une seconde couche de silicium amorphe hydrogéné de type n sur la seconde couche intrinsèque de silicium amorphe hydrogéné, et

i) réaliser le câblage désiré des électrodes.

13. Procédé selon la revendication 12, selon lequel l'épaisseur de la couche produite par réaction interfaciale n'est pas supérieure à 10 nm.

14. Procédé selon la revendication 12 ou 13, selon lequel la couche produite par réaction interfaciale possède la forme de bandes.

15. Procédé selon l'une quelconque des revendications 12 à 14, selon lequel la couche métallique est déposée par évaporation à une température de 100 à 300°C.

16. Procédé selon l'une quelconque des revendications 12 à 15, selon lequel le métal inclut au moins l'un de Cr, Mo, W, Ta, Ti, Pt, V, Zr, Nb, Ni, Hf, Pd, Rh et Co.

17. Procédé selon l'une quelconque des revendications 12 à 16, selon lequel le métal est du Cr.

18. Procédé selon l'une quelconque des revendications 12 à 16, selon lequel le métal est du Ni.

# FIG. 1
## PRIOR ART

# FIG. 2

*FIG. 3*

*FIG. 4*

# FIG. 5

# FIG. 6